(19) Europäisches Patentamt European Patent Office Office européen des brevets

(11) **EP 3 869 641 B1**

(12) **FASCICULE DE BREVET EUROPEEN**

(45) Date de publication et mention de la délivrance du brevet:
**19.10.2022 Bulletin 2022/42**

(21) Numéro de dépôt: **21157523.8**

(22) Date de dépôt: **17.02.2021**

(51) Classification Internationale des Brevets (IPC):
**H01S 5/14** *(2006.01)*     *H01S 5/10* *(2021.01)*
*H01S 5/06* *(2006.01)*     *H01S 5/068* *(2006.01)*

(52) Classification Coopérative des Brevets (CPC):
**H01S 5/142;** H01S 5/0612; H01S 5/06821;
H01S 5/1032

(54) **DISPOSITIF D'ÉMISSION LASER À EFFET VERNIER ACCORDABLE**

ABSTIMMBARER VERNIER-EFFEKT-LASER

TUNABLE LASER DEVICE UTILIZING VERNIER EFFECT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **19.02.2020 FR 2001659**

(43) Date de publication de la demande:
**25.08.2021 Bulletin 2021/34**

(73) Titulaires:
• **Commissariat à l'énergie atomique et aux énergies alternatives**
**75015 Paris (FR)**
• **THALES**
**92400 Courbevoie (FR)**

(72) Inventeurs:
• **HASSAN, Karim**
**38054 GRENOBLE CEDEX 09 (FR)**
• **WILMART, Quentin**
**38054 GRENOBLE CEDEX 09 (FR)**

(74) Mandataire: **Brevalex**
**95, rue d'Amsterdam**
**75378 Paris Cedex 8 (FR)**

(56) Documents cités:
• **TIN KOMLJENOVIC ET AL: "Widely-Tunable Ring-Resonator Semiconductor Lasers", APPLIED SCIENCES, vol. 7, no. 7, 17 juillet 2017 (2017-07-17), page 732, XP055688482, DOI: 10.3390/app7070732**
• **KOMLJENOVIC TIN ET AL: "Monolithically Integrated High-Q Rings for Narrow Linewidth Widely Tunable Lasers", IEEE JOURNAL OF QUANTUM ELECTRONICS, vol. 51, no. 11, 1 novembre 2015 (2015-11-01), pages 1-10, XP011587838, ISSN: 0018-9197, DOI: 10.1109/JQE.2015.2480337 [extrait le 2015-10-19]**
• **ELFAIKI HAJAR ET AL: "Ultra Wide Hybrid III-V on Silicon Tunable Laser", 2018 EUROPEAN CONFERENCE ON OPTICAL COMMUNICATION (ECOC), IEEE, 23 septembre 2018 (2018-09-23), pages 1-3, XP033447609, DOI: 10.1109/ECOC.2018.8535328**
• **LI ANG ET AL: "Fundamentally cancel backscattering in silicon microrings", 2017 CONFERENCE ON LASERS AND ELECTRO-OPTICS EUROPE & EUROPEAN QUANTUM ELECTRONICS CONFERENCE (CLEO/EUROPE-EQEC), 25 juin 2017 (2017-06-25), page 1, XP033240055, DOI: 10.1109/CLEOE-EQEC.2017.8087136**

## Description

## DOMAINE TECHNIQUE

Le domaine de l'invention est celui de l'optique intégrée et plus particulièrement celui de la photonique sur silicium. Dans ce cadre, l'invention porte sur un dispositif d'émission laser accordable sur une large gamme de longueurs d'onde d'émission.

## TECHNIQUE ANTÉRIEURE

Les premières démonstrations de lasers à semiconducteurs accordables en longueur d'onde remontent aux années 80 avec des lasers à réseaux de Bragg distribués (lasers DBR pour « Distributed Bragg Reflector ») qui exploitent des miroirs en tant que structure de rétroaction optique permettant de former une cavité résonante pour un milieu amplificateur.

Depuis, le principe de fonctionnement des lasers accordables est demeuré le même avec une cavité Fabry-Pérot optiquement fermée par deux miroirs dont au moins un est partiellement réfléchissant et un élément de filtrage spectral qui dans le cas d'un laser DBR est en fait intégré à la fonction miroir. De façon à maximiser la puissance émise et afin d'assurer un comportement mono-fréquentiel du laser, la longueur d'onde privilégiée par le filtre doit être en coïncidence avec un des modes possibles de la cavité Fabry-Pérot, ajustable par une section de phase, et si possible positionnée dans une zone spectrale où le gain est important.

Afin d'accroitre l'accordabilité des lasers à semi-conducteurs, laquelle est limitée à environ 10 nm avec un filtre DBR, il est possible de modifier les réseaux de Bragg en ajoutant des sous-périodicités légèrement différentes afin de bénéficier d'un effet Vernier selon une méthode connue sous le nom de SG-DBR (« Sampled-Grating DBR »). Cette modification a permis de démontrer une accordabilité supérieure à 50 nm. Néanmoins, les miroirs SG-DBR doivent posséder une longueur importante de façon à assurer correctement leur fonction de filtrage, ce qui engendre une efficacité très faible des éléments chauffants utilisés pour les accorder et donc un coût de fonctionnement énergétique important.

Pour y remédier, il est possible de remplacer un DBR par des éléments filtrants et réfléchissants distincts, respectivement un résonateur en anneau et un miroir de Sagnac qui est un miroir en boucle connu pour être un bon miroir achromatique. Par example, la publication de Tin Komljenovic et al. "Widely-Tunable Ring-Resonator", Applied Sciences, vol. 7, no. 7, page 732 (2017) décrit un dispositif d'émission laser accordable en longueur d'onde selon le préambule de la revendication 1.

Comme rapporté dans la publication de Hajar Elfaiki et al. « Ultra Wide Hybrid III-V on Silicon Tunable Laser", ECOC 2018, il est possible d'atteindre une accordabilité de 90 nm en exploitant un résonateur en anneau multiple constitué de deux anneaux résonants mis en série, ces deux anneaux possédant des périmètres très légèrement différents afin d'obtenir un effet Vernier. En effet, la différence de périmètre engendre une différence d'intervalle spectral libre (ISL ou FSR pour « Free Spectral Range ») de sorte que les peignes de transmission de deux anneaux dont les ISLs sont légèrement différents ne vont coïncider qu'en certains pics de transmission. Le résonateur en anneau présente alors un ISL total supérieur à celui de chaque anneau.

Dans un tel filtre spectral accordable utilisant un effet Vernier obtenu au moyen de deux anneaux, l'intervalle spectral libre est effectivement donné par

$$FSR_t = \frac{FSR1 \times FSR_2}{FSR_2 - FSR_1}$$ où $FSR1$ et $FSR2$ désignent l'intervalle spectral libre respectif de chacun des anneaux. En fixant la résonance d'un anneau et en déplaçant celle de l'autre anneau d'un multiple de $\Delta FSR = FSR_2 - FSR_1$ (par exemple à l'aide d'une chaufferette), la résonance globale du filtre peut être modifiée. Quand on passe d'une résonance globale à une autre la différence d'ordre de résonance entre les deux anneaux résonateurs est toujours inférieure à 1.

Pour obtenir un effet Vernier présentant une large accordabilité, des anneaux de petits périmètres sont généralement exploités dans la mesure où leur intervalle spectral libre respectif est élevé ce qui permet de maximiser $FSR_t$. A titre d'exemple, une accordabilité de 100 nm pourrait être obtenue avec deux anneaux de diamètre $P_1 = 67,5\ \mu$m et $P_2 \approx 63,59\ \mu$m (soit environ 10 $\mu$m de rayon pour $n_g$=4.46 à $\lambda$=1310 nm), donnant ainsi $FSR_1 \approx 5,7$ nm et $FSR_2 \approx 6,05$ nm, soit $FSR_t \approx 98$ nm.

L'augmentation de l'accordabilité au-delà de 90 nm se heurte toutefois à plusieurs phénomènes qui empêchent une sélection stable de la fréquence d'émission, que ce soit du fait de pertes accrues dans certaines bandes spectrales ou bien à cause de réflexions parasites.

Une technique pour limiter les réflexions parasites provenant d'un anneau résonnant, rapportée dans la publication de Ang Li et Win Bogaerts, « Fundamental suppression of backscattering in silicon microrings », Opt. Express 25(3) 2017, consiste à doter l'anneau résonnant d'un miroir en boucle à réflectivité accordable en longueur d'onde au moyen d'une section de contrôle de phase prenant la forme d'un interféromètre de Mach Zehnder.

Toutefois, cette technique présente un problème majeur pour être exploitée dans un laser accordable. En effet, en ajoutant une section de contrôle de phase et une boucle de Sagnac, le trajet optique est considérablement allongé (autour d'un facteur 3), ce qui réduit l'intervalle spectral libre de l'anneau donné par

$$FSR = \frac{\lambda^2}{n_g P}$$ , où P est le périmètre du résonateur, $n_g$ l'indice de groupe et $\lambda$ la longueur d'onde.

L'exploitation de cette technique conduirait à des périmètres plus de trois fois plus importants, supérieurs à 200 μm. Partant d'un anneau de 200 μm de long, son intervalle spectral libre serait, pour $n_g$=4,46 à λ=1310 nm, d'environ 1,924 nm. Une accordabilité de 100 nm pourrait alors être atteinte en disposant d'un deuxième anneau présentant un intervalle spectral libre d'environ 1,9615 nm. Mais avec un écart si réduit entre les FSR respectifs de chaque anneau ($\Delta FSR \approx 0.03 nm$), la transmission du système Vernier se retrouve largement dégradée avec un SMSR (*Side Mode Suppresion Ratio*) de l'ordre de 12dB.

On constate ainsi qu'avec des résonateurs en anneau augmentés d'une boucle de Sagnac, le périmètre est important donc le FSR est faible (typiquement < 2 nm). On peut éventuellement jouer sur $\Delta FSR$ pour augmenter FSRt, mais on doit respecter la condition $\Delta FSR > FWHM$ (Full Width at Half Maximum) pour ne pas dégrader le SMSR. En effet, si les résonances sont trop proches, le système peut présenter une résonance globale trop peu amortie et conduire à l'apparition d'un mode laser parasite. En conclusion, la technique de limitation des réflexions parasites conduit à un $FSR_t$ d'un système Vernier à 2 anneaux trop faible pour une large accordabilité.

## EXPOSÉ DE L'INVENTION

Un objectif de l'invention est d'étendre l'accordabilité d'un laser à semiconducteurs sans pour autant en dégrader le SMSR afin de garantir une émission laser mono-fréquence.

A cet effet, l'invention propose un dispositif d'émission laser accordable en longueur d'onde qui comprend un premier et un deuxième miroir de Sagnac ainsi qu'une cavité délimitée par le premier et deuxième miroir de Sagnac. La cavité comprend un milieu amplificateur et un filtre spectral accordable utilisant l'effet Vernier. Ledit filtre comprend au moins trois anneaux résonnants agencés en cascade, chaque anneau résonnant intégrant un miroir en boucle à réflectivité accordable en longueur d'onde.

Certains aspects préférés mais non limitatifs de ce dispositif sont les suivants : chaque anneau résonnant dudit filtre comprend une section interférométrique de Mach-Zehnder;

chacun des premier et deuxième miroirs de Sagnac est composé d'un coupleur directionnel adiabatique rebouclé par un guide d'onde ;
la cavité comprend en outre une section de déphasage ;
l'un des premier et deuxième miroirs de Sagnac est partiellement réfléchissant ;
il comprend en outre, à l'extérieur de la cavité du côté de celui des premier et deuxième miroirs de Sagnac qui est partiellement réfléchissant, un réseau incliné de couplage vers/depuis une fibre optique monomode ;
le milieu amplificateur comprend une hétérostructure III-V.

## BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

La figure 1 est un schéma représentant une architecture possible d'un dispositif d'émission laser conforme à l'invention ;
La figure 2 est un schéma d'un anneau résonnant doté d'un miroir en boucle à réflectivité accordable en longueur d'onde ;
La figure 3 illustre la coïncidence à 1261 nm des pics d'émission de chacun de cinq anneaux résonnants d'un filtre spectral pouvant être utilisé dans le dispositif selon l'invention, en l'absence de déphasage appliqué aux anneaux ;
La figure 4 représente les pics d'émission, autour de 1361 nm, de chacun des anneaux résonnants du filtre spectral à cinq anneaux, en l'absence de déphasage appliqué aux anneaux ;
La figure 5 représente la coïncidence à 1361 nm des pics d'émission de chacun de cinq anneaux résonnants du filtre spectral à cinq anneaux, en présence d'un déphasage appliqué à cet effet aux anneaux ;
La figure 6 représente le spectre en transmission du filtre à cinq anneaux respectivement en l'absence de déphase appliqué aux anneaux (coïncidence des résonances individuelles à 1231 nm) et en présence d'un déphasage appliqué aux anneaux pour atteindre une coïncidence des résonances individuelles à 1361 nm.

## EXPOSÉ DÉTAILLÉ DE MODES DE RÉALISATION PARTICULIERS

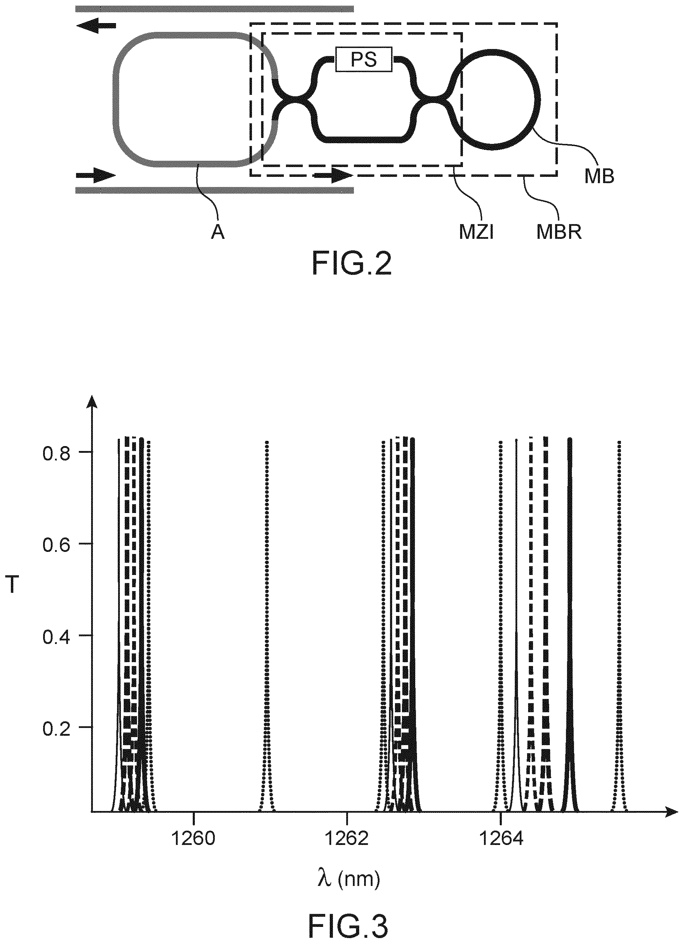

En référence à la figure 2, l'invention a pour objet un dispositif d'émission laser accordable en longueur d'onde 1. Ce dispositif comprend :

- un premier et un deuxième miroir de Sagnac M1, M2 ;
- une cavité CA délimitée par le premier et deuxième miroir de Sagnac M1, M2, la cavité comprenant un milieu amplificateur MA et un filtre spectral accordable utilisant l'effet Vernier F.

Dans un mode de réalisation privilégié de l'invention, le milieu amplificateur comprend une hétérostructure III-V. Par hétérostructure de type III-V, on entend l'utilisation de matériaux binaires, ternaires, quaternaires, pouvant être choisis dans la liste non exhaustive suivante : InP, GaAs, InGaAlAs, InGaAsP, AlGaAs, InAsP, AlInAs. L'hétérostructure d'un tel milieu amplificateur, aussi appelé milieu à gain, peut comporter un empilement de diverses couches, comme par exemple un empilement de couches formant des puits quantiques pris en sandwich entre une première couche dopée, de préférence dopée N, et une seconde couche dopée, de préférence dopée P.

Ce mode privilégié repose ainsi sur la technologie d'intégration hétérogène de matériaux III-V avec du silicium qui permet de réaliser des circuits photoniques associant des sources optiques III-V avec des composants à base de silicium. L'intégration hétérogène III-V sur silicium peut notamment consister à coller une portion de matériau actif III-V capable d'émettre de la lumière sur un circuit « passif » gravé à la surface d'un substrat silicium sur isolant SOI (« Silicon On Insulator »). Un circuit photonique à section active hybride III-V sur silicium comprend ainsi généralement :

- un substrat SOI portant un guide d'onde silicium,
- une structure à gain qui comporte au moins un milieu amplificateur optique à hétérostructure III-V, rapportée par collage sur le substrat SOI,
- une fine couche d'oxyde servant de couche de liaison et qui sépare la structure à gain du guide d'onde silicium.

L'hétérostructure III-V est agencée de manière à être sus-jacente à une section du guide d'onde silicium pour former avec celui-ci une section de guide d'onde hybride. Au niveau de cette section de guide d'onde hybride, la proximité verticale des guides III-V et silicium entraine l'apparition d'un mode optique couplé, issu de l'hybridation entre les modes propres fondamentaux de chacun de ces guides. Ce mode couplé est transféré depuis la section active hybride III-V/Silicium vers des sections passives de propagation de la lumière purement en silicium agencés de part et d'autre de la section de guide d'onde hybride. Le guide d'onde en silicium est à cet effet structuré pour présenter une section de transition modale (*taper*) entre la section active hybride et les sections de propagation.

Les sections de propagation et la section hybride sont délimitées par les miroirs de Sagnac M1, M2 qui constituent ainsi une structure de rétroaction optique à même de former une cavité résonante CA pour le milieu amplificateur MA. L'un des miroirs, ici M1, est un miroir à haute réflectivité qui présente par exemple une réflectivité supérieure à 90%, tandis que l'autre miroir, ici M2, est un miroir à faible réflectivité (miroir partiellement réfléchissant) qui présente par exemple une réflectivité inférieure à 50%, typiquement entre 35 et 10%. Le miroir à faible réflectivité forme ainsi la sortie optique du dispositif d'émission laser 1. Cette sortie optique peut être doté d'un réseau de couplage CI vers/depuis une fibre optique monomode. Ce réseau de couplage est préférence un réseau incliné qui présente l'avantage d'une réflectivité réduite. Le principe d'un tel réseau incliné est par exemple décrit dans la publication de Yanlu Li et al., «Reflectionless tilted grating couplers with improved coupling efficiency based on a silicon overlay", IEEE Photonics Technology Letters, vol. 25, no. 13, pp. 1195-1198, Jul. 2013.

En comparaison avec un miroir DBR fonctionnant par diffraction, un miroir de Sagnac est composé d'un coupleur directionnel rebouclé par un guide d'onde et fonctionne uniquement par interférence constructive/destructive entre deux guides, ce qui en simplifie la fabrication puisqu'il n'y a pas de réseau sub-longueur d'onde à réaliser. Le concept avantageux de boucle de Sagnac a été largement utilisé dans le domaine des fibres optiques, un domaine où les guides en silice montrent une dispersion chromatique très faible, si bien que l'on considère les boucles de Sagnac fibre comme achromatique. Cette propriété n'est cependant plus valide en optique intégrée car lorsque l'on utilise un coupleur directionnel à base de micro-guides en silicium, le taux de couplage est dépendant de la longueur d'onde. Néanmoins, dans un mode de réalisation privilégié de l'invention, chacun des premier et deuxième miroirs de Sagnac M1, M2 exploite un coupleur directionnel adiabatique. Le coupleur directionnel adiabatique présente des rapports de couplage relatif quasi parfait sur 100 nm de bande passante, typiquement des rapports de couplage relatif compris entre 0,45 et 0,55 sur toute la bande passante, par exemple sur une bande comprise entre 1260 nm et 1360 nm. Un exemple d'élaboration d'un tel coupleur adiabatique est par exemple donné dans la publication de Karim Hassan et al., « Robust silicon-on-insulator adiabatic splitter optimized by metamodeling », Applied Optics 56(8) 2017.

Outre le milieu amplificateur MA, la cavité CA peut comprendre une section de contrôle de phase P apte à accorder les modes de la cavité Fabry-Pérot CA en étant pour cela thermiquement contrôlée au moyen d'une chaufferette disposée au-dessus de la section P.

La cavité CA comprend par ailleurs un filtre spectral accordable utilisant l'effet Vernier F. Ce filtre est un résonateur à anneau multiple qui comprend plusieurs anneaux résonnants agencés en cascade. Comme représenté sur la figure 2, chaque anneau résonnant A intègre un miroir en boucle à réflectivité accordable en longueur d'onde MBR. Comme on l'a vu précédemment de tels anneaux présentent une faible réflectivité du fait de l'ajout du miroir en boucle à réflectivité accordable qui permet de supprimer les modes contra-propagatifs générés par la rétrodiffusion de lumière *(backscattering)*. Dans un mode de réalisation privilégié représenté sur la figure 2, chaque anneau résonnant A intègre un miroir en boucle MB et une section de phase ajustable. La section de phase ajustable est typiquement une section interférométrique de Mach-Zehnder MZI qui comprend deux bras aptes à être déphasés l'un de l'autre au moyen d'un élément de déphasage thermo-optique PS apte à agir sur l'un des bras.

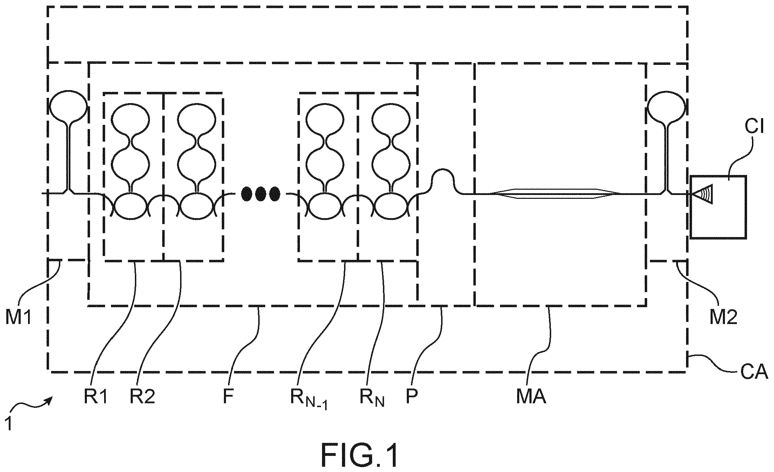

L'ajout à chaque anneau résonnant du miroir à réflectivité ajustable augmente de façon notable la longueur effective de chaque résonateur. Comme on l'a vu précédemment, cette augmentation réduit l'intervalle spectral libre, ce qui n'est pas souhaitable pour obtenir une grande accordabilité. Pour tirer tout de même profit de ce type de résonateur faiblement réflectif tout en bénéficiant d'un effet Vernier offrant une large accordabilité, le filtre du dispositif selon l'invention n'est pas assuré par deux anneaux comme c'est le cas dans l'état de l'art mais par un plus grand nombre d'anneaux, à savoir au moins trois anneaux résonnants R1, R2, $R_{N-1}$, $R_N$ comme représenté sur la figure 1.

Un avantage de tel nombre d'anneaux consiste en ce qu'on n'est plus limité par le FSR global des systèmes d'anneaux : deux résonances peuvent coïncider, si la troisième ou la quatrième résonance ne coïncide pas, il n'y aura pas de résonance globale du système. C'est-à-dire que contrairement au cas à deux anneaux, la différence d'ordre entre les résonateurs peut être supérieure à 1. Ainsi on n'a plus besoin de choisir un ΔFSR le plus faible possible puisque que l'accordabilité n'est plus limitée par $FSR_t = \frac{FSR1 \times FSR_2}{FSR_2 - FSR_1}$.

On peut donc atteindre à la fois une grande accordabilité et un bon SMSR. Un exemple de dimensionnement des au moins trois anneaux du filtre est détaillé ci-après, en liaison avec un exemple de réalisation où le filtre comprend cinq anneaux.

On considère un anneau de référence présentant un intervalle spectral libre FSRo. Les autres anneaux du filtre ont un FSR exprimé tel que $FSR_i = \alpha_i FSR_0$. L'intervalle spectral libre des sous-systèmes à 2 anneaux 0 et i est donné par $FSR_{i-0} = \frac{\alpha_i}{1-\alpha_i} FSR_0$ tandis que l'intervalle spectral libre du système à N anneaux est donné par $\prod \frac{\alpha_i}{1-\alpha_i} FSR_0$.

Par exemple, si on considère quatre anneaux tels que $FSR_1 = 0,9* FSR_0$, $FSR_2 = 0,8*FSR_0$ et $FSR_3 = 0,7*FSR_0$, l'intervalle spectral libre global du système est de 0.9*0.8*0.7/(0.1*0.2*0.3) = 84*$FSR_0$, soit 126 nm si on prend un $FSR_0$ typique de 1,5 nm. On constate donc que l'intervalle spectral libre d'un système à N anneaux augmente avec le nombre d'anneaux ce qui rend accessible une plus grande plage d'accordabilité.

Soit un guide d'onde d'indice effectif $n_{eff}$ et un périmètre d'anneau résonnant minimum $L_0$. On choisit la longueur d'onde à atteindre la plus basse du système : $\lambda_0 = 1.26\mu m$. L'ordre de résonance de l'anneau 0 s'exprime selon $m_0 = entier(\frac{L_0 n_{eff}}{\lambda_0})$, et son intervalle

spectral libre vaut $FSR_0 = \frac{L_0 n_{eff}}{m_0} - \frac{L_0 n_{eff}}{m_0-1}$.

On choisit ensuite une plage d'accordabilité, par exemple Δλ = 100nm, et on note $\lambda_m = \lambda_0 + \Delta\lambda$. Le décalage d'ordre de résonance pour que l'anneau 0 atteigne la longueur d'onde maximum s'exprime selon $N = m_0 - \frac{L_0 n_{eff}}{\lambda_m}$ et l'intervalle spectral libre de l'anneau 0 à $\lambda_m$ selon $FSR_m = \frac{L_0 n_{eff}}{m_0-N} - \frac{L_0 n_{eff}}{m_0-N-1}$.

Le choix des autres anneaux en termes de différence d'intervalle spectral libre par rapport à l'anneau de référence 0 (typiquement en prenant ΔFSR > FWHM) s'effectue comme suit. L'anneau i doit présenter un intervalle spectral libre $FSR_i$ en imposant sa résonance avec la condition $\lambda i = \lambda_0$. D'où $m_i = 1 + entier(\frac{\lambda_0}{FSR_i})$ et $L_i = \frac{\lambda_0 m_i}{n_{eff}}$. Ce choix garantit une coïncidence à $\lambda_0$ mais n'est pas restrictif sur la géométrie des autres anneaux. La figure 3 illustre le spectre en transmission T en fonction de la longueur d'onde d'un filtre à cinq anneaux, de diamètres respectifs 350, 368, 388, 411 et 437μm, pour lesquels on a imposé une coïncidence de résonance à $\lambda_0$ = 1261 nm.

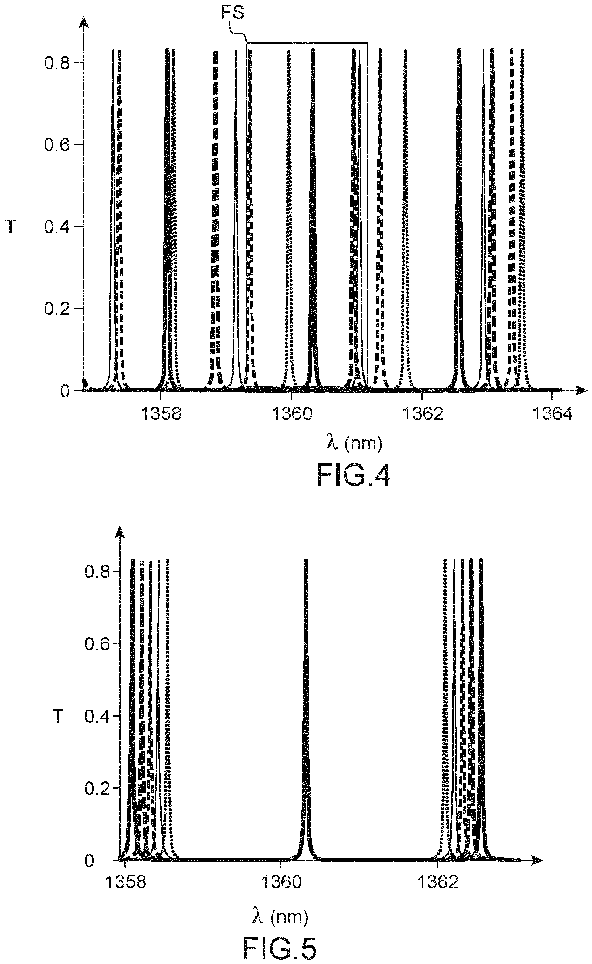

Le filtre devant être accordable sur la plage Δλ, on recherche une résonance du système d'anneaux à $\lambda_s$ tel que $\lambda_0 < \lambda_s < \lambda_m$. Pour cela, pour chaque anneau on détermine $N_{i,s} = m_i - entier(\frac{L_i n_{eff}}{\lambda_s})$, c'est à dire l'ordre de résonance qui se rapproche le plus de $\lambda_s$ à $\lambda_{i,s} = \frac{n_{eff} L_i}{m_i - N_{i,s}}$. On calcule alors le FSR de chaque anneau à $\lambda_s$, $FSR_{i,s}$. Pour $\lambda_s$ donné, et comme représenté par la fenêtre FS sur la figure 4, il y a toujours une résonance de chaque anneau à moins d'un demi FSR.

On cherche ensuite à accorder les anneaux pour les faire coïncider à $\lambda_s$. Le déphasage à appliquer à chaque anneau s'écrit $\Delta\phi_i = 2\pi(\lambda_s - \lambda_{i,s})/FSR_{i,s}$. Ce déphasage peut être appliqué au moyen d'une chaufferette disposée au-dessus de chaque anneau. On a représenté sur la figure 4 les résonances individuelles des anneaux à $\lambda_0$ + 100nm, en l'absence de déphasage appliqué aux anneaux. On constate une absence de résonance globale du système. On a par ailleurs représenté sur la figure 5 les résonances individuelles des anneaux à $\lambda_0$ + 100nm, avec application du déphasage $\Delta\phi_i$. On constate une coïncidence des résonances individuelles et donc une résonance globale du système.

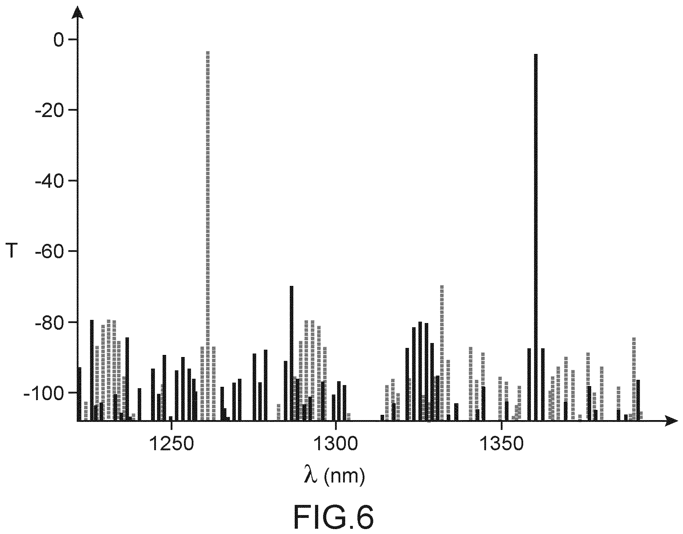

On a par ailleurs représenté sur la figure 6 le spectre en transmission T du filtre à 5 anneaux sans appliquer de déphasage (en traits pointillés ; résonance à 1261 nm) et en appliquant $\Delta\phi_i$ (en traits pleins ; résonance à 1361 nm). Le déphasage appliqué est inférieur à pi, c'est-à-dire que la résonance des anneaux est déplacée au maximum d'un demi FSR. Le filtre est ainsi accordable sur 100nm avec un SMSR de plus de 60dB.

En définitive, le dispositif d'émission laser selon l'invention peut être constitué d'un réseau de couplage faibles réflexions, de miroirs de type boucle de Sagnac avec une bande passante améliorée par l'utilisation de coupleurs directionnels adiabatiques large bande, et au cœur du mécanisme d'accordabilité une série d'anneaux résonants à faible réflectivité. L'utilisation d'au moins trois anneaux permet de les rendre compatibles avec la réalisation d'un effet Vernier offrant une large accordabilité.

## Revendications

1. Dispositif d'émission laser accordable en longueur d'onde (1), comprenant :

   - un premier et un deuxième miroir de Sagnac (M1, M2) ;
   - une cavité (CA) délimitée par le premier et deuxième miroir de Sagnac (M1, M2), la cavité comprenant un milieu amplificateur (MA) et un filtre spectral accordable utilisant l'effet Vernier (F),

   où ledit filtre (F) comprend au moins trois anneaux résonnants ($R_1$, $R_2$, $R_{N-1}$, $R_N$) agencés en cascade, **caractérisé par** chaque anneau résonnant intégrant un miroir en boucle à réflectivité accordable en longueur d'onde (MBR).

2. Dispositif selon la revendication 1, dans lequel chaque anneau résonnant dudit filtre comprend une section interférométrique de Mach-Zehnder (MZI).

3. Dispositif selon l'une des revendications 1 et 2, dans lequel chacun des premier et deuxième miroirs de Sagnac (M1, M2) est composé d'un coupleur directionnel adiabatique rebouclé par un guide d'onde

4. Dispositif selon l'une des revendications 1 à 3, dans lequel la cavité (CA) comprend en outre une section de déphasage (P).

5. Dispositif selon l'une des revendications 1 à 4, dans lequel l'un des premier et deuxième miroirs de Sagnac est partiellement réfléchissant.

6. Dispositif selon la revendication 5, comprenant en outre, à l'extérieur de la cavité du côté de celui des premier et deuxième miroirs de Sagnac qui est partiellement réfléchissant, un réseau incliné de couplage vers/depuis une fibre optique monomode (CI).

7. Dispositif selon l'une des revendications 1 à 6, dans lequel le milieu amplificateur comprend une hétérostructure III-V.

## Patentansprüche

1. Wellenlängenabstimmbare Laseremissionsvorrichtung (1), umfassend:

   - einen ersten und einen zweiten Sagnac-Spiegel (M1, M2);
   - eine Vertiefung (CA), die durch den ersten und zweiten Sagnac-Spiegel (M1, M2) begrenzt ist, wobei die Vertiefung ein Verstärkungsmedium (MA) und einen Spektralfilter umfasst, der unter Verwendung des Vernier-Effekts (F) abstimmbar ist, wobei der Filter (F) mindestens drei Resonanzringe ($R_1$, $R_2$, $R_{N-1}$, $R_N$) umfasst, die kaskadenartig angeordnet sind, **dadurch gekennzeichnet, dass** jeder Resonanzring einen Schleifenspiegel mit wellenlängenabstimmbarer Reflektivität (MBR) enthält.

2. Vorrichtung nach Anspruch 1, wobei jeder Resonanzring des Filters einen Abschnitt der Mach-Zehnder-Interferometrie (MZI) umfasst.

3. Vorrichtung nach einem der Ansprüche 1 und 2, wobei jeder der ersten und zweiten Sagnac-Spiegel (M1, M2) aus einem adiabatischen Richtkoppler besteht, der durch einen Wellenleiter rückgekoppelt ist.

4. Vorrichtung nach einem der Ansprüche 1 bis 3, wobei die Vertiefung (CA) ferner einen Phasenverschiebungsabschnitt (P) umfasst.

5. Vorrichtung nach einem der Ansprüche 1 bis 4, wobei einer der ersten und zweiten Sagnac-Spiegel teilweise reflektierend ist.

6. Vorrichtung nach Anspruch 5, die ferner außerhalb der Vertiefung auf der Seite desjenigen des ersten und zweiten Sagnac-Spiegels, der teilweise reflektierend ist, ein Kopplungsnetz umfasst, das zu/von einer optischen Einmodenfaser (CI) geneigt ist.

7. Vorrichtung nach einem der Ansprüche 1 bis 6, wobei das Verstärkungsmedium eine III-V-Heterostruktur umfasst.

## Claims

1. A wavelength tunable laser emission device (1), comprising:

   - a first and a second Sagnac mirror (M1, M2);

- a cavity (CA) delimited by the first and second Sagnac mirrors (M1, M2), the cavity comprising an amplifying medium (MA) and a tunable spectral filter using the Vernier effect (F),

wherein said filter (F) comprises at least three resonant rings (R$_1$, R$_2$, R$_{N-1}$, R$_N$) arranged in cascade, **characterised in that** each resonant ring integrates a loop mirror with tunable wavelength reflectivity (MBR).

2. The device according to claim 1, wherein each resonant ring of said filter comprises a Mach-Zehnder interferometric (MZI) section.

3. The device according to any one of claims 1 to 2, wherein each of the first and second Sagnac mirrors (M1, M2) is comprised of an adiabatic directional coupler fed back through a waveguide.

4. The device according to any one of claims 1 to 3, wherein the cavity (CA) further comprises a phase shift section (P).

5. The device according to any one of claims 1 to 4, wherein one of the first and second Sagnac mirrors is partially reflective.

6. The device according to claim 5, further comprising, outside the cavity on the side of that one of the first and second Sagnac mirrors which is partially reflective, a tilted grating coupler to/from a single-mode optical fibre (CI).

7. The device according to any one of claims 1 to 6, wherein the amplifying medium comprises a III-V heterostructure.

**FIG.1**

FIG.2

FIG.3

FIG.4

FIG.5

FIG.6

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **TIN KOMLJENOVIC et al.** Widely-Tunable Ring-Resonator. *Applied Sciences,* 2017, vol. 7 (7), 732
- **HAJAR ELFAIKI et al.** « Ultra Wide Hybrid III-V on Silicon Tunable Laser. *ECOC,* 2018
- **YANLU LI et al.** Reflectionless tilted grating couplers with improved coupling efficiency based on a silicon overlay. *IEEE Photonics Technology Letters,* Juillet 2013, vol. 25 (13), 1195-1198
- **KARIM HASSAN et al.** Robust silicon-on-insulator adiabatic splitter optimized by metamodeling. *Applied Optics,* 2017, vol. 56 (8